# EUROPEAN PATENT APPLICATION

(11) **EP 0 843 338 A1**
(43) Date of publication of application: **20.05.1998**
(21) Application number: 96480105.4
(22) Date of filing: 15.11.1996
(51) Int. Cl.: H01L 21/00

(54) **An improved boat for supporting semiconductor wafers**

(71) Applicant: Upsys, 91100 Corbeil-Essonnes (FR)
(72) Inventor: Deseez, Christian, 77310 ST Fargeau (FR)
(74) Representative: Klein, Daniel Jacques Henri

(57) **Abstract**

A wafer carrier for heat treatment of semiconductor wafers in a vertical furnace. The wafer carrier (10) is comprised of two parts: an innovative wafer boat (11) and a conventional heat insulation cylinder or pedestal (12). The wafer boat is disposed atop the pedestal. The wafer boat comprises four support rods (15) that are disposed between top and bottom disc-shaped plates (13,14). According to the present invention, each plate is provided with hollow projections (17) and the support rod extremities are machined to produce tips (19) that are adapted to matingly engage in said hollow projections to fit snugly therewith. The disclosed wafer boat can be easily assembled or disassembled without damage even in a manufacturing environment. In particular, as a result of this releasable construction, all the parts of the wafer boat are easily detachable for cleaning or repair. On the other hand, more flexibility is offered in that rods/plates of different materials or design can be combined in-situ to meet specific manufacturing requirements.

## Description

### FIELD OF INVENTION

The present invention relates to the processing of disk-shaped objects such as semiconductor wafers and more particularly to an improved boat used to support semiconductor wafers during heat treatments in a furnace or reactor. The wafer boat of the present invention finds very useful applications in any step of wafer thermal processing, including atmospheric and low pressure chemical vapor deposition (CVD), anneal, wet or dry oxidation, diffusion and the like. In particular, the wafer boat of the present invention is perfectly adapted to vertical CVD systems. In this type of CVD systems, the wafers are disposed horizon tally and the plasma reactant gas flows across serially arranged wafers perpendicular to the surface thereof. The present invention also encompasses wafer carriers incorporating said improved wafer boat.

### BACKGROUND OF THE INVENTION

There is a great variety of designs in the wafer carriers that are currently used in the semiconductor industry for the thermal processing of semiconductor wafers. In particular, their design strongly depends on whether they are used in horizontal or vertical furnaces. For instance, wafer carriers that are used in CVD vertical furnaces are usually comprised of two parts: the boat which includes rods provided with slots to support the wafers and the heat insulation cylinder or pedestal. The pedestal is comprised of a plurality of circular or disc-shaped plates that are combined in a known manner. These circular plates are formed of a heat insulating material to keep the pedestal hot and isolate the wafer boat from the CVD systemload/unload door as known for those skilled in the art. The common standard in the industry is to have all parts of the wafer boat and the pedestal fused together to produce two unitary structures which are carefully assembled to form the wafer carrier. To that end, the wafer boat which is provided with three pins at its bottom surface is gently laid down on the top surface of the pedestal, where it is aligned and secured thanks to adequate registration and centering means. As a first consequence of the integral construction of the wafer boat, because quartz glass is a very brittle material, the wafer boat is very fragile. If only one constituting part is broken or is deformed when it is exposed to the considerable temperature variations produced during said thermal processing, the whole wafer boat needs to be rejected as being out of usage. There is obviously no repair capability at all with unitary structures of this type. Moreover, the production of these hand-made wafer boats is relatively complex and expensive. Another great concern with such wafer boats is the lack of flexibility in the processing of batches having different numbers of wafers or when different slot spacings or profiles are required.

Thus, a real need exists for an improved wafer boat which could be utilized in any of the thermal processing steps performed in CVD vertical furnaces and that would allow larger flexibility in the repair or cleaning of the wafer boat and its conditions of use than is possible with conventional wafer boats presently available. It is also desirable to reduce fabrication and exploitation costs of such conventional wafer boats.

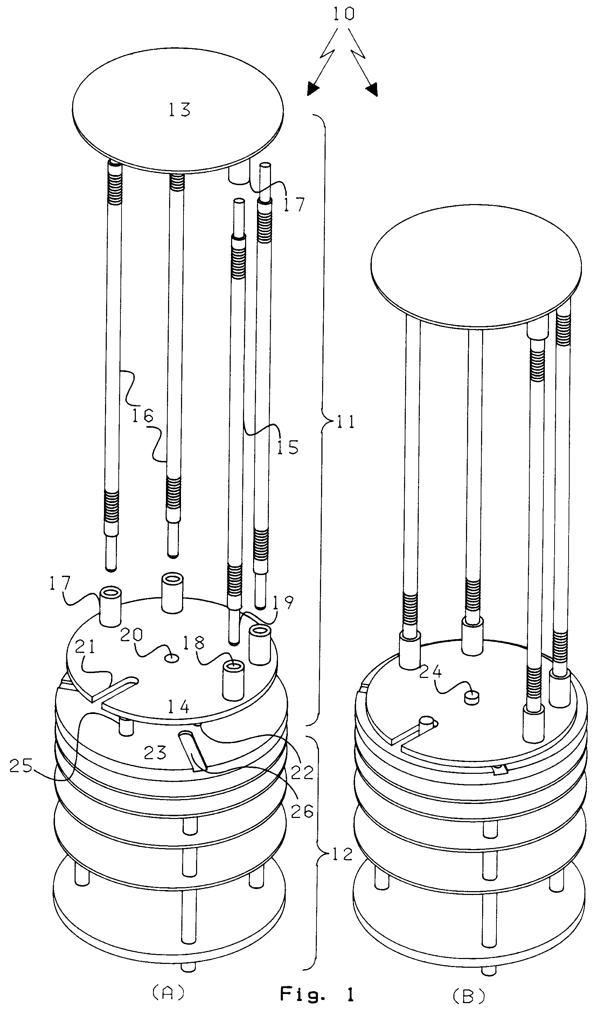

EP-A-0 100 539 (Ref. D1) describes wafer carriers for thermal processing of semiconductor wafers in either a horizontal or a vertical furnace. In both cases, the wafer carrier can be entirely dismantled in its constituting parts. In the first version that is specifically designed for horizontal furnaces (see Figs. 1 and 5), the wafer carrier comprises two holding ends provided with receiving notches that are adapted to receive square-shaped support rods, which, in turn, are correspondingly provided with engaging notches for mating together. A pair of corresponding notches has an adequate profile for perfect fitting. In the other version adapted to vertical furnaces, the support rods are secured to square-shaped holes formed into the holding ends. The extremity of the support rod is provided with a notch and a wedge is necessary to secure said notch to the holding end (see Figs. 17 to 19).

The wafer carriers of Ref. D1 are obviously of the as semblable type since every constituting part is detachable, but the described version for vertical heat treatment does not appear to be satisfactory in an manufacturing environment. If the wedge is inserted too loosely there is a clear risk of an undesired disassembling during the thermal processing step. On the contrary, if the wedge is inserted too tightly there is a risk of breaking the rod or the holding end during the assembly and the disassembly operations. As a result, these operations may be difficult and risky too. Finally, all the constituting parts are made of the same quartz glass material and there is no teachings in this reference, that different materials could be combined to form the wafer carrier. Likewise, there is no teachings as to the use of rods having different slot spacings or profiles.

### SUMMARY OF THE PRESENT INVENTION

It is therefore a primary object of the present invention to provide an improved wafer boat for use in the thermal processing of semiconductor wafers typically in CVD vertical furnaces.

It is another object of the present invention to provide an improved wafer boat which is comprised of a plurality of removable parts instead of a unitary structure where parts are welded together.

It is yet another object of the present invention to provide an improved wafer boat, the constituting parts of which can be easily assembled and disassembled.

It is still another object of the present invention to provide an improved wafer boat which, in the event of local damage (e.g. break or deformation of any part), can be easily repaired for further use only by exchanging that part that has undergone damage.

It is still another object of the present invention to provide an improved wafer boat the construction of which does not require welding by a blow-lamp at the final stage of assembling the constituting parts thereof avoiding thereby any deformation that would cause cause poor dimension tolerances.

It is still further another object of the present invention to provide an improved wafer boat which can be easily adapted to any change of the number of semiconductor wafers to be processed in manufacturing environment.

It is still further another object of the present invention to provide an improved wafer boat which can include rods having different slot profiles (e.g. to facilitate the load/unload of semiconductor wafers by a robot) and spacings (e.g. to accomodate different types of diffusion).

It is still further another object of the present invention to provide an improved wafer boat which can be easily constructed by assembling parts of different materials (e.g. quartz glass and silicon carbide) to meet specific applications where the use of different materials is advantageous.

It is still further another object of the present invention to provide an improved wafer boat which can be directly mounted on the pedestal by using the top plate thereof as one holding end to reduce fabrication cost of the whole wafer carrier.

In accordance with the above and other objects, there is disclosed hereunder an innovative wafer boat for supporting a plurality of wafers disposed horizontally in a CVD vertical furnace. In a preferred embodiment, the wafer boat of the present invention comprises two holding ends, typically disc-shaped plates, spaced from each other vertically with a predetermined distance therebetween and at least three support rods extending across said disc plates and coupled thereto. Each rod is provided with slots to adequately support the wafers at a determined spacing. Said wafer boat being characterized in that the disc-shaped plates and the extremities of said support rods are adapted to provide a connection therebetween which is both releasable and tight. As a result, all constituting parts of the wafer boat can be easily assembled or disassembled without any risk of damage. In this preferred embodiment, this is achieved by fixing hollow projections having a central blind hole on said plates and machining the extremities of said support rod with enough precision so that a snugly fitting is obtained when a rod extremity is inserted in the corresponding blind hole.

Another feature of this invention is that the top circular plate of most commercially available pedestals can be adapted to receive said support rods thereby saving one holding end in the final wafer carrier assembly.

Still another feature of this invention is that the constituting parts of the wafer boat, i.e. the plates and the rods can be constructed using different materials and that the slots made in the rods may have different spacings and profiles.

The novel features believed to be characteristic of this invention are set forth in the appended claims. The invention itself, however, as well as other objects and advantages thereof, may be best understood by reference to the following detailed description of an illustrated preferred embodiment to be read in conjunction with the accompanying drawings.

### BRIEF DESCRIPTION OF THE DRAWINGS

Fig. 1 is comprised of Fig. 1(A) which shows an exploded perspective view of one specific embodiment of a wafer carrier comprised of the innovative wafer boat of the present invention and a conventional pedestal and Fig. 1(B) which shows the perspective view of the wafer carrier of Fig. 1(A) once assembled.

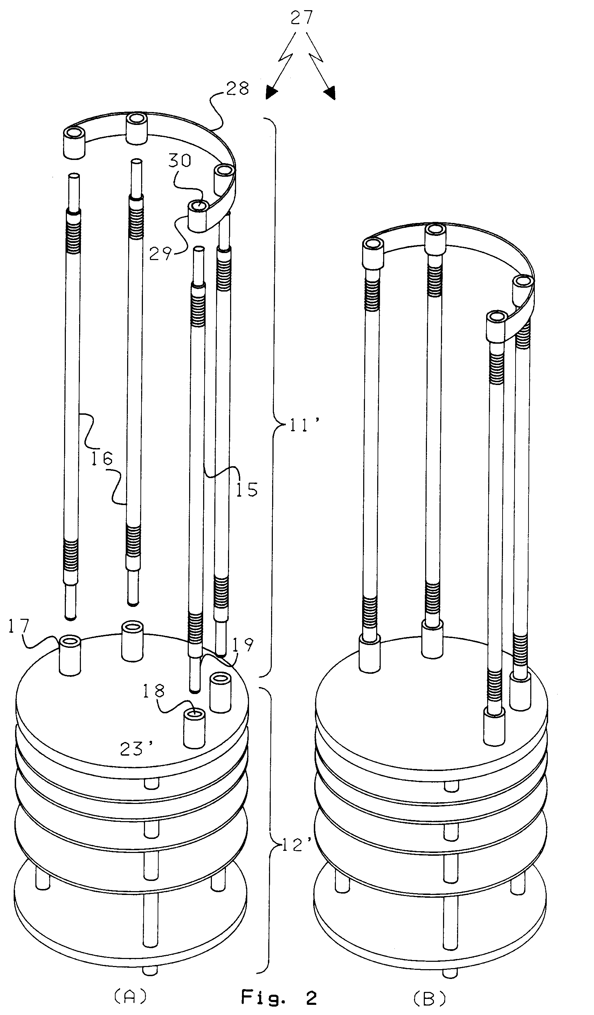

Fig. 2 is comprised of Fig. 2(A) which shows an exploded perspective view of another embodiment of the wafer carrier of Fig. 1 wherein the conventional pedestal is modified to become a part of the innovative wafer boat and Fig. 2(B) which shows the perspective view of the wafer carrier of Fig. 2(A) once assembled.

### DESCRIPTION OF THE PREFERRED EMBODIMENTS

Fig. 1 shows an exploded view of a first embodiment of a heat treatment wafer carrier bearing numeral 10 according to the present invention. As apparent from Fig. 1(A), wafer carrier 10 is essentially comprised of two parts: the improved wafer boat 11 of the present invention and the heat insulation cylinder or pedestal 12, the wafer boat 11 being disposed atop the pedestal 12. The model of pedestal shown in Fig. 1 (A) is integral or unitary, i.e. all its constituting parts are welded together to form a single block structure. As mentioned above, the construction of pedestal 12 is known per se and will not be described here any more.

The improved wafer boat 11 of the present invention first includes two disc-shaped top and bottom plates 13 and 14 respectively that are spaced from each other of a predetermined distance. It further includes four support rods or rails 15, that are erected between said top and bottom plates 13 and 14 and are provided with slots or grooves 16 as standard to support the wafers (not shown). Slots 16 have a vertical width which is a little larger than the thickness of the wafers. The configuration shown in Fig. 1(A), i.e. with equal spacing between slots allows the reactant gas to flow uniformly, thereby permitting an excellent uniformity in the processing over the entire surface of the wafer. However, variable spacing could be envisioned as well. The wafers are loaded/unloaded in/out the slots 16 by the transfer arm of a handling robot (not shown) as standard.

According to an essential feature of the present invention, each plate and each support rod extremity are adapted so that the coupling therebetween is tight enough to produce an integral-like assembly but not too much to make it releasable. Different releasable connecting means can be envisioned to meet these contradictory objectives.

In the first embodiment of Fig. 1(A), four hollow projections referenced 17 are illustrated for the bottom plate 14. Each projection has a blind hole 18. These hollow projections are obtained by cutting an annular quartz glass rod with a standard diamond saw into pieces having the desired length. In a typical application the length L of the projections 17 is 21 mm and the external diameter is 20 mm. These projections 17 are bored with a drilling machine to provide a central hole having an internal diameter D of 12 mm. It is recommended to have the projection length L greater than the internal diameter D for better precision of the fitting. A L/D ratio equal to about 2 appears adequate in most applications. Four pieces are fabricated then welded on the bottom plate 14 at adequate locations on the circumference to leave a recess of a sufficient size for enabling the transfer arm of a robot to load/unload the wafers in/out the rod slots. Of course, corresponding projections in the top and bottom plates are in perfect registration. Still in this first embodiment, the rod extremities have preferably a special design. For each support rod 15, its extremities are thinned, e.g. by grinding, to form a tip 19 with a plane shoulder at the rod/tip interface. The tips 19 are machined e.g. by grinding to have a length of 20 mm and a diameter just inferior to the internal diameter of the projections mentioned above. As a matter of fact, the adjustment blind hole/tip is perfectly defined by data 12g6/12H7 of norm ISO E02-350 to meet the two key objectives mentioned above: once the different parts constituting the wafer boat are combined, they must produce an unitary structure, i.e. all parts are firmly secured, but the coupling must not be too tight to allow easy assembling/disassembling of the wafer boat. In other words, tips 19 are not only matingly engageable in said blind holes 18 but they must fit snugly therewith. With this design, the tip shoulder acts a a stop member on the annular surface of the hollow projection. Other coupling means could be envisioned as well, the above technique takes in account the fact that disc-shaped plates 13 and 14 are generally not thick enough (thickness in the range of 12 mm) to ensure proper fitting of the rod in a blind hole made therein. Should thicker plates be used (at the cost of an additional thermal inerty of the wafer boat), such a blind hole could be drilled in the plate to receive the rod extremity. In this case, the adjustment mentioned above should still be made for excellent fitting but on a few microns of the rod extremity external surface. Finally, the bottom plate 14 is provided with a centering hole 20, an alignment notch 21 and three pins 22 (only one is visible in Fig. 1(A)) are disposed at its lower surface as standard. As apparent from Fig. 1(A), pedestal 12 is comprised of a plurality of circular plates. The surface of the pedestal top plate now referenced 23' is provided with two pegs. A first peg 24 (visible in Fig. 1(B)) fits with the centering hole 20 and the other peg 25 fits with the alignment notch 21 made in bottom plate 14 for centering and registration purposes respectively as known for those skilled in the art. Three grinded zones referenced 26 corresponding to pins 22 are also provided to top plate 23'. These zones cooperate with the pins 22 to ensure that the surfaces of plates 14 and 23 are be perfectly planar and parallel, Therefore, because the constituting parts of the wafer boat 11 are now "mechanically" assembled once perfectly machined, the need of welding using a blow-lamp (burner) is thus no longer required, and as a consequence, the global dimension tolerances of the wafer boat 11 are significantly improved.

Fig. 1(B) shows the wafer boat 10 of Fig. 1(A) once assembled.

As a direct result of its dismantling structure, the wafer boat 11 of Fig. 1 has high flexibility. In particular, it now possible to provide the rods 16 with slots of different profiles and of different spacings. For instance, still referring to Fig. 1(A), the two support rods 16 that are the most spaced can be provided with V-shaped slots (to facilitate the wafer load/unload operation) while the two others can be provided with U-shaped slots for a better holding of the wafers. Likewise, the slot spacing may be choosen equal or variable, by assembling the adequate rods in-situ depending on specific process requirements. Moreover, new materials such as silicon carbide, alumina, sintered ceramic or graphite have been recently used to fabricate wafer boats. They have a better temperature behavior when compared to quartz glass, but unfortunately, these materials are much more expensive than quartz (by at least one order of magnitude). According to the present invention it is now possible to produce wafer boats combining different materials to meet manufacturing needs. For instance, if thermal rigidity is seeked for a specific batch, the support rods can be made of SiC while the remaining parts of the wafer boat are made of quartz glass. If the wafers must be grounded during the heat treatment, all parts can be made of SiC except top plate 13. A good compromise between cost and reliability can now be obtained for the improved wafer boats of the present invention.

Fig. 2 shows an exploded perspective view of another wafer carrier referenced 27 according to a second embodiment of the present invention. Now turning to Fig. 2(A), the wafer carrier 27 which is comprised of wafer boat 11' and pedestal 12' directly derives from wafer carrier 10 of Fig. 1, except in that a few changes have been made. First, the bottom plate 14 of wafer boat 10 has been eliminated. The top plate 23 of the pedestal 12 of Fig. 1 can be provided with hollow projections according to the teachings of the present invention. These projections are constructed and attached to the top plate now referenced 23' according to the above described technique. As a result, not only one plate is saved for cost reduction, but there is provided a novel wafer carrier assembly. Another change may consist in the replacement of the top disc-shaped plate 13 by an arcuate member 28 that is provided with a plurality of apertured cylinders 29 which play the same role that projections 17.

Fig. 2(B) shows the wafer carrier 27 of Fig. 2(A) once assembled.

It is desirable to use a cylindrical configuration for the wafer boat in order to ensure wafer processing uniformity.

However, other configurations could be envisioned as well. Likewise, different modifications could be made without departing from the scope of the present invention. For instance, support rods could have a square section instead of a circular one, ... etc.

So far, conventional wafer boats have been usually fabricated of quartz glass. They are hand-made, requiring thereby skilled labor and are relatively expensive. By their very nature, the constituting parts (rods, plates,... ) are fragile, so that they were frequently broken during use, causing the loss of the whole wafer boat. In addition, wafer boats are also characterized by poor dimensional tolerances because the constituting parts are welded at the final stage of the assembly. All these in conveniences are now overcome with the above described improved wafer boats of the present invention. In addition, the latter offer much more flexibility in terms of choice of the materials (e.g. silicon carbide, alumina,...) used to fabricate the different constituting parts thereof, and in the design of the support rods because slots of different profiles and spacings may now be mixed upon request to meet any specific request of the manufacturing.

The innovative wafer boats/carriers of the present invention are applicable to the handling of wafers in areas such as oxidation, diffusion, chemical vapor deposition, etching, cleaning and the like, all steps that are essential to the wafer batch thermal processing.

## Claims

1. A vertical wafer boat (11) for supporting a number of semiconductor wafers or the like during processing comprising:
a top holding end (13);
a bottom holding end (14) that is spaced from said top end by a predetermined distance;
a plurality of support rods (15) extending across said holding ends and coupled thereto; said rods being provided with slots (16) having a determined spacing to support said wafers horizontally; and,
connecting means (17, 18, 19) for tightly but releasably coupling the extremities of said support rods to said holding ends.

2. The vertical wafer boat of claim 1 wherein said top and bottom holding ends consists of disc-shaped plates.

3. The vertical wafer boat of claim 2 wherein said connecting means consists of a plurality of hollow projections (17), each being provided with a blind hole (18) fused on the interior faces of said plates.

4. The vertical wafer boat of claim 3 wherein the extremity of each support rod is such as it can be matingly engaged into its corresponding blind hole to fit snugly therewith.

5. The vertical wafer boat of claim 4 wherein said support rod extremity is thinned by machining to produce a tip (19) adapted for tight insertion into said blind hole.

6. The vertical wafer boat of claim 5 wherein said thinning is performed according to norm G6/H7.

7. The vertical wafer boat of any claim 2 to 6 wherein the ratio between the length L of the projection and the in ternal diameter D of the blind hole is approximately 2.

8. The vertical wafer boat of any above claim wherein at least two support rods are constructed with different materials.

9. The vertical wafer boat of claim 8 wherein said different materials includes quartz glass and a material selected in the group consisting of silicon carbide, alumina, sintered ceramic and graphite.

10. The vertical wafer boat of any above claim wherein at least two support rods have a different slot profile or spacing.

11. A wafer carrier (27) for supporting a number of semiconductor wafers or the like during processing consisting of a wafer boat (11') disposed onto a heat insulation pedestal (12') comprising:
a top holding end (13);
a bottom holding end (23) that is spaced from said top end by a predetermined distance;
a plurality of support rods (15) extending across said holding ends and coupled thereto; said rods being provided with slots (16) having a determined spacing to support said wafers horizontally;
connecting means (17, 18, 19) for tightly but releasably coupling the extremities of said support rods to said holding ends;
wherein said bottom holding end is the top plate of the pedestal.

12. The vertical wafer boat of claim 11 wherein said top holding end consists of a disc-shaped plate and said connecting means consists of a plurality of hollow projections (17), each being provided with a blind hole (18) fused on the faces of said plates that are facing one another.

13. The vertical wafer boat of claim 12 wherein the extremity of each support rod is such as it can be matingly engaged into its corresponding blind hole to fit snugly therewith.

14. The vertical wafer boat of claim 13 wherein said support rod extremity is thinned by machining to produce a tip (19) adapted for tight insertion into said blind hole.
